# EUROPÄISCHE PATENTANMELDUNG

(11) **EP 0 790 149 A2**
(43) Veröffentlichungstag der Anmeldung: **20.08.1997**
(21) Anmeldenummer: 96118944.6
(22) Anmeldetag: 27.11.1996
(51) Int. Cl.: B60R 11/02

(54) **Befestigungsvorrichtung für ein elektronisches Gerät**

(30) Priorität: 17.02.1996 DE 29602857 U
(71) Anmelder: ROBERT BOSCH GMBH, 70442 Stuttgart (DE)
(72) Erfinder: Strohmeier, Wolfgang, 31137 Hildesheim (DE)

(57) **Zusammenfassung**

Um eine Befestigungsvorrichtung für ein elektronisches Gerät (20) mit einem Gehäuse für die Verwendung in einem Kraftfahrzeug derart zu verbessern, daß diese bei möglichst kompakten Aufbau eine möglichst einfache Befestigung von Geräte-Gehäusen in einem Kraftfahrzeug ermöglicht, wird vorgeschlagen, einen am Befestigungsort des Gerätes (20) befestigbaren, auf die Gehäuseform angepaßten Rahmen (10) vorzusehen, wobei das Gehäuse (20) im befestigten Zustand seitlich nicht über den Rahmen (10) übersteht. Vorteilhafter Weise weist der Rahmen mehrere von dem Rahmen (10) aufwegstehende stabile Stehbolzen (16) auf, an denen das Gehäuse(20) mittels Schrauben (17) befestigbar ist.

## Beschreibung

### Stand der Technik

Die Erfindung betrifft eine Befestigungsvorrichtung für ein elektronisches Gerät mit einem Gehäuse für die Verwendung in einem Kraftfahrzeug.

In Kraftfahrzeugen gibt es eine Vielzahl von Geräten, die nicht zwingend im Bereich des Armaturenbretts angeordnet werden müssen, da sie weder der Information von Betriebsdaten des Fahrzeuges dienen, noch in anderer Weise vom Fahrer auf diese Geräte zurückgegriffen werden muß. Derartige Geräte sind beispielsweise Verstärker von in dem Fahrzeug angeordneten Rundfunkempfängern, Kassettenabspielgeräten, Compact-Disc-Abspielgeräten, Geräte zum Telefonempfang, aber auch Unfalldatenschreiber u.dgl. Diese Geräte werden in den meisten Fällen an Kofferraumwänden, -böden u.dgl. befestigt. Hierbei entstehen erhebliche Anordnungs- und Befestigungsprobleme.

So muß einerseits eine sichere Befestigung des Geräts am Befestigungsort auch bei extremen Einsatzbedingungen des Fahrzeugs, z.B. großen Temperaturunterschieden oder hohen, am Gerät auftretenden Kräften u.dgl., sichergestellt sein, andererseits soll die Befestigungsvorrichtung keinen großen Raum einnehmen, was inbesondere bei einer Befestigung im Kofferraum eines Fahrzeugs von großer Bedeutung ist, da durch das zu befestigende Gerät sowie die Befestigungsvorrichtung Kofferraumvolumen verlorengeht. Schließlich muß die Befestigungsvorrichtung auch so flexibel gestaltet sein, daß sie an den unterschiedlichsten Befestigungsorten in unterschiedlichen Fahrzeugen befestigbar ist.

Zur Befestigung eines Verstärkers in einem Kofferraum ist es beispielsweise bekannt, an den Stirnseiten der Gehäusegrundfläche des Verstärkergehäuses einen Schraubenflansch oder Schraubleisten vorzusehen, die einer direkten Befestigung des Verstärkergehäuses an einer Kofferraumwand oder an dem Kofferraumboden dient.

Nachteilig bei dieser Art und Weise der Befestigung ist es, daß die Schraubflansche oder Schraubleisten seitlich über das Gehäuse überstehen und daher zusätzlichen Platz benötigen, der für eine anderweitige Nutzung verlorengeht. Außerdem gestaltet sich die Befestigung des Verstärkergehäuses insbesondere bei unzugänglichen Stellen als schwierig.

Eine andere Befestigungsart eines Verstärkers in einem Kraftfahrzeug sieht vor, daß das Verstärkergehäuse über seine seitlich wegstehenden Kühlrippen direkt an einer Montagefläche befestigt wird. Hierfür ist erforderlich, die Kühlrippen zur Aufnahme einer Befestigungsschraube mit Bohrungen zu versehen. Dies ist jedoch nachteilig, weil es nicht nur einen zusätzlichen erheblichen Arbeitsaufwand darstellt, sondern auch hinsichtlich einer effizienten Kühlung ungünstig ist.

Aus der DE 41 29 864 A1 ist schließlich eine Befestigungsvorrichtung für ein elektronisches Gerät mit quaderförmigem Gehäuse für die Verwendung in einem Kraftfahrzeug bekannt, bei welchem ein mit dem Gehäuse des Geräts verbindbarer Träger und ein am Befestigungsort des Gerätes befestigbarer Halter vorgesehen sind, die als Blechteile geformt sind und mittels Zungen-Schlitz-Verbindungen zusammengefügt und in Fügerichtung verschraubt werden.

Bei dieser Befestigungsvorrichtung wird zwar eine äußerst kompakte Befestigung des elektronischen Geräts in einem Kraftfahrzeug erzielt. Von Nachteil ist es jedoch, daß der Kalter und der Träger verhältnismäßig kompliziert ausgestaltete Blechteile sind, die eine aufwendige Herstellung erfordern und hierdurch bei der Herstellung hohe Kosten verursachen. Darüber hinaus gestaltet sich die Befestigung des Gehäuses an einer Montagefläche umständlich. Zunächst muß nämlich der Kalter an dem Befestigungsort des Kraftfahrzeuges sowie der Träger an dem Gehäuse des Geräts befestigt werden, erst dann kann der Träger zusammen mit dem Gehäuse an dem Halter befestigt werden. Schließlich erfordert die Befestigung des Halters aufgrund seiner ebenen, flächigen Gestalt eine ebene Montagefläche. Weist beispielsweise die Montagefläche Erhöhungen oder Unebenheiten auf, so müssen am Halter zusätliche Befestigungselemente befestigt werden, die eine Befestigung des Halters mit Abstand von der Montagefläche ermöglichen.

Diese zusätzlichen Befestigungselemente erhöhen nicht nur den Befestigungsaufwand, sondern auch die Kosten der gesamten Befestigungsvorrichtung.

Der Erfindung liegt daher die Aufgabe zugrunde, eine Befestigungsvorrichtung der gattungsgemäßen Art derart zu verbessern, daß diese bei möglichst kompaktem Aufbau eine möglichst einfache Befestigung von Geräte-Gehäusen in einem Kraftfahrzeug ermöglicht.

### Vorteile der Erfindung

Diese Aufgabe wird bei einer Befestigungsvorrichtung der eingangs beschriebenen Art erfindungsgemäß dadurch gelöst, daß ein am Befestigungsort des Geräts befestigbarer, auf die Gehäuseform angepaßter Rahmen vorgesehen ist, der Be£estigungselemente zur lösbaren Befestigung des Gehäuses aufweist dergestalt, daß das Gehäuse im befestigten Zustand seitlich nicht über den Rahmen übersteht.

Die Befestigung des Gehäuses mittels eines Rahmens mit Befestigungselementen, an denen wiederum das Gehäuse direkt befestigt wird, hat den großen Vorteil, daß lediglich noch ein einziges Teil zur Befestigung des Gehäuses an einer Montagefläche, beispielsweise an einer Kofferraumwand oder an dem Kofferraumboden nötig ist. Darüber hinaus ermöglicht der Rahmen die Befestigung an den unterschiedlichsten Befestigungsorten, insbesondere auch an Befestigungsorten, die nicht eben sind oder Erhebungen, beispielsweise weitere befestigte Teile u.dgl. aufweisen. Da der Rahmen so ausgebildet ist, daß das Gehäuse im befestigten Zustand seitlich nicht über ihn übersteht, ist auch eine sehr kompakte Befestigung des Geräts möglich.

Rein prinzipiell könnte der Rahmen auf die unterschiedlichste Weise ausgebildet sein. Vorteilhafterweise umfaßt der Rahmen jedoch mehrere flache, miteinander verbundene Stege. Durch diese Art der Ausgestaltung ist der Rahmen nicht nur auf einfache Weise herzustellen und damit kostengünstig, sondern er weist auch eine genügende Stabilität zur Befestigung eines Geräts in einem Kraftfahrzeug auf.

Insbesondere um eine stabile und trotzdem einfache Befestigung des Gehäuses an dem Rahmen zu ermöglichen, sind die Befestigungselemente vorteilhafterweise von dem Rahmen wegstehende, mit einem Innengewinde versehene Stehbolzen, an denen das Gehäuse mittels Schrauben befestigbar ist. Diese Stehbolzen ermöglichen eine besonders schnelle und problemlose Befestigung des Gehäuses, welches lediglich noch auf die Stehbolzen aufgesetzt und mittels der Schrauben an den Stehbolzen befestigt werden muß.

Vorteilhafterweise sind die Stehbolzen einstückig an dem Rahmen ausgebildet, wodurch eine besonders hohe Stabilität des gesamten Rahmens und damit der Befestigung des Gehäuses erzielt wird.

Insbesondere zur schnellen, einfachen und universell einsetzbaren Montage des Rahmens am Befestigungsort, beispielsweise am Kofferraumboden oder an einer Wand des Kofferraums weist der Rahmen eine Vielzahl von Bohrungen auf, die der Aufnahme von Befestigungsschrauben dient. Durch diese Vielzahl von Bohrungen ist eine individuelle Anpassung der Befestigung auf die räumlichen Gegebenheiten am Befestigungsort möglich. Von besonderem Vorteil ist es dabei, daß der Rahmen aufgrund seiner Ausgestaltung und der Anordnung der Bohrungen gewissermaßen gleichzeitig als Bohrschablone verwendet werden kann.

### Zeichnung

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine perspektivische Darstellung einer erfindungsgemäßen Befestigungsvorrichtung in Form eines Rahmens und
- Fig. 2: eine perspektivische Darstellung der in Fig. 1 dargestellten Befestigungsvorrichtung mit einem an dieser befestigten Gehäuse.

### Beschreibung der Ausführungsbeispiele

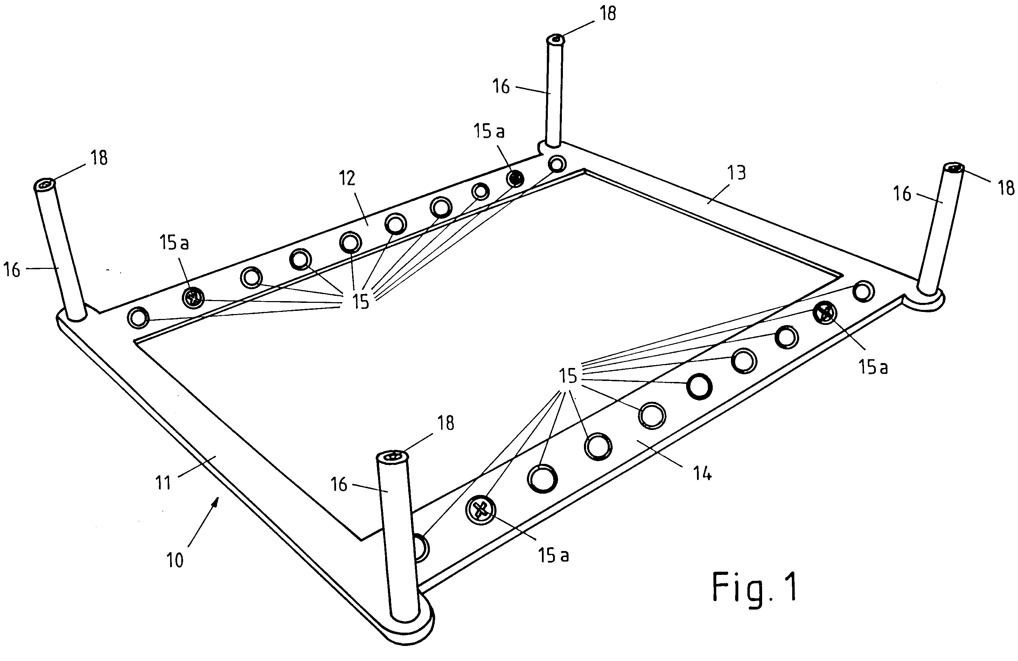

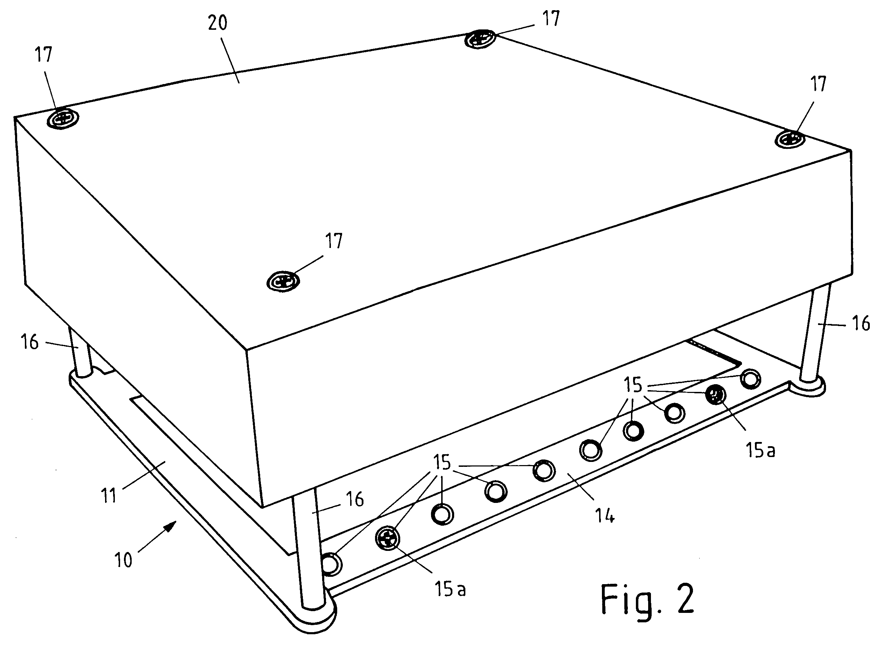

Ein Ausführungsbeispiel einer Befestigungsvorrichtung, dargestellt in Fig. 1 und Fig. 2, hat die Gestalt eines Rahmens 10, der mehrere flache, miteinander verbundene Stege 11, 12, 13, 14 umfaßt.

Der Rahmen 10 kann beispielsweise als Blech-Stanzteil hergestellt sein, so daß die Stege 11, 12, 13, 14 jeweils einstückig miteinander verbunden sind. In zwei sich gegenüberliegenden Stegen 12, 14 sind Bohrungen 15 vorgesehen, die der Aufnahme von Befestigungsschrauben 15a dienen. Dabei können in den Stegen 12, 14 jeweils eine oder mehrere Befestigungsschrauben 15a angeordnet sein - abhängig von den räumlichen Gegebenheiten am Befestigungsort.

Zur Befestigung des Rahmens 10 an einer Montagefläche, beispielsweise einem Kofferraumboden oder einer Kofferraumwand wird der Rahmen 10 zunächst am Befestigungsort fixiert und dient so gleichzeitig als Bohrschablone. Nach Vornahme der Bohrungen wird der Rahmen 10 mittels der in die Bohrungen 15 einführbaren Befestigungsschrauben 15a am Befestigungsort auf einfachste Weise befestigt.

Als Befestigungselemente für das Gehäuse 20 sind von dem Rahmen 10 wegstehende, mit einem Innengewinde 18 versehene Stehbolzen 16 vorgesehen, die einstückig an dem Rahmen 10 angeordnet sind.

Wie aus Fig. 2 hervorgeht, ist das Gehäuse 20 beispielsweise eines Kraftfahrzeug-Verstärkers auf die Stehbolzen 16 aufgesetzt und mit Schrauben 17, die in die Innengewinde 18 der Stehbolzen 16 eingreifen, befestigt. Die Befestigung des Gehäuses 20 erfolgt dabei erst, nachdem der Rahmen 10 an seinem Befestigungsort befestigt ist.

Wie insbesondere aus Fig. 2 hervorgeht, ist der Rahmen 10 auf die Form des Gehäuses 20 angepaßt. Durch die Ausbildung des Rahmens 10 mittels der Stege 11, 12, 13, 14 kann der Rahmen 10 auf jede beliebige - auch nicht rechteckförmige - Gehäuseform angepaßt sein. Dabei ist der Rahmen 10 einschließlich der Befestigungselemente 16 so ausgebildet, daß er seitlich nicht über das Gehäuse 20 übersteht, daß er mit anderen Worten eine Fläche überdeckt, die kleiner oder gleich der Grundfläche des Gehäuses 20 ist.

Der Rahmen 10 ist vorteilhafterweise aus Metall gebildet, er kann aber auch aus Kunststoff gefertigt sein.

## Patentansprüche

1. Befestigungsvorrichtung für ein elektronisches Gerät mit einem Gehäuse für die Verwendung in einem Kraftfahrzeug, **dadurch gekennzeichnet,** daß ein am Befestigungsort des Geräts befestigbarer, auf die Gehäuseform angepaßter Rahmen (10) vorgesehen ist, der Befestigungselemente zur lösbaren Befestigung des Gehäuses (20) aufweist dergestalt, daß das Gehäuse (20) im befestigten Zustand seitlich nicht über den Rahmen (10) übersteht.

2. Befestigungsvorrichtung nach Anspruch 1, dadurch gekennzeichnet, daß der Rahmen (10) mehrere flache, miteinander verbundene Stege (11, 12, 13, 14) umfaßt.

3. Befestigungsvorrichtung nach Anspruch 1, dadurch gekennzeichnet, daß die Befestigungselemente von dem Rahmen wegstehende, mit einem Innengewinde (18) versehene Stehbolzen (16) sind, an denen das Gehäuse (20) mittels Schrauben (17) befestigbar ist.

4. Befestigungsvorrichtung nach Anspruch 3, dadurch gekennzeichnet, daß die Stehbolzen (16) einstückig an dem Rahmen (10) ausgebildet sind.

5. Befestigungsvorrichtung nach Anspruch 1 oder 2, dadurch gekennzeichnet, daß in wenigstens einem Steg (12, 14) eine Vielzahl von Bohrungen (15) zur Aufnahme von Befestigungsschrauben (15a) vorgesehen ist.

6. Befestigungsvorrichtung nach einem der voranstehenden Ansprüche, dadurch gekennzeichnet, daß der Rahmen (10) aus Metall oder Kunststoff besteht.
